# EUROPEAN PATENT APPLICATION

(11) **EP 4 421 830 A1**
(43) Date of publication of application: **28.08.2024**
(21) Application number: 23382172.7
(22) Date of filing: 24.02.2023
(51) Int. Cl.: H01F 5/02, H01F 27/10

(54) **LIGHT LIQUID COOLED POWER ELECTRONIC UNIT**

(71) Applicant: Premo, SL, 29590 Campanillas, Málaga (ES)
(72) Inventor: CAÑETE CABEZA, Claudio, 29631 Benalmádena (ES); ROJAS CUEVAS, Antonio, 29190 Málaga (ES); NAVARRO PÉREZ, Francisco Ezequiel, 08006 Barcelona (ES); RODRÍGUEZ MUNÍN, Raquel, 29680 Estepona (ES); BLANCO ORTIZ, Juan, 29680 Estepona (ES)
(74) Representative: Torner, Juncosa I Associats, SL

(57) **Abstract**

Light liquid cooled power electronic unit comprising several electromagnetic components (10), a cooling circuit (20) with several intermediate cooling regions (23), each in close contact with one electromagnetic component (10), allowing heat transmission by conduction; and a first wall (31) the first wall (31) containing at least a first flat manifold (21) constitutive of a portion of the cooling circuit (20); wherein each intermediate cooling region (23) of the cooling circuit (20) is defined within a bobbin (13) interposed between an electroconductive coil (12) and a magnetic core (11) of each electromagnetic component (10); the first flat manifold (21) including first connection openings (41) oriented towards the electromagnetic components (10), each intermediate cooling region (23) of the cooling circuit (20) being tightly connected to the first flat manifold (21) through the first connection openings (41) by a fitting perpendicular to a main surface of the first wall (31).

## Description

### Technical field

The present invention is directed towards a light liquid cooled power electronic unit, for example, an on board power converter for an electric or hybrid vehicle.

The proposed power electronic unit comprises several electromagnetic components arranged to process electrical power, and a cooling circuit configured to efficiently evacuate the heat generated in said electromagnetic components.

### Background of the Invention

Typically, the liquid cooled power electronic unit is an on board power converters for electric and hybrid vehicles that make use of customized electromagnetic components to increase power density of the power electronic unit.

Power density is a key factor in these converters, since every gram of weight saved can be used as an additional gram of battery, and thus of vehicle range. The same is true for the volume occupied, the less volume, the more space available for the battery.

The increase in power density means that in the same volume reserved for the electromagnetic components, higher densities of electric current can be introduced. This electric current is converted into magnetic flux inside the electromagnetic components, and then returns to electric energy at the end of conversion or storage (depending on whether the electromagnetic component is an inductor, a transformer or a filter choke).

During the conversion of electrical energy to magnetic energy, losses are transmitted in the form of heat. Since the aim is to increase the power per unit volume (W/m³) and in a magnetic component the energy is mostly transferred to the load (typical (Pout-Pin)/Pin efficiencies exceed 95%), the result is that power losses are concentrated in smaller volumes, thus raising the temperature of the device. As the power density increases, these losses become larger and larger in the same size. Therefore, it is particularly important to effectively evacuate this waste heat from the losses as quickly as possible from the electromagnetic components.

An inefficient design in heat dissipation can cause the component to reach extreme temperatures or even never be able to stabilize inside the converter at a stable temperature (the heat flux would not be properly dissipated in steady state). It is the temperature that produces adverse effects and the breakdown of the component, either by deterioration of the insulation causing short circuits or by reaching the temperature at which the core ceases to be ferromagnetic or Curie temperature, also causing overcurrent and short circuits. Therefore, the main limiting factor for maximizing the power per unit volume at constant efficiency is the temperature until the next limiting factor is reached, which is the core saturation induction (Bsat).

Therefore, to increase the power density of the electromagnetic components, reducing their weight, is essential to increase the efficiency of the cooling circuit to ensure an efficient evacuation of the heat to prevent the adverse effects of the overheating described above.

Also, an efficient design of the cooling circuit enables a better cooling using less cooling fluid by reducing the longitude of the cooling circuit further reducing the overall weight of the power unit.

The liquid cooled electronic power units are already known. For example, it is common to use a first wall containing a first flat manifold inside the first wall through which the cooling fluid circulates. In these known examples, the electromagnetic components are in close contact with said first wall, dissipating heat by thermal transmission through said first wall. This solution only provides cooling to one side of each electromagnetic component, not providing an efficient cooling thereof.

Examples are also known in which each electromagnetic component is externally enveloped and in contact with a portion of the refrigerant circuit. This solution increases the external cooling of each individual electromagnetic component, but not of central regions thereof, and makes it more difficult and expensive to manufacture.

The present invention solves the above and other problems.

### Description of the Invention

The present invention concerns a light liquid cooled power electronic unit as defined in claim 1, for example, an on board power converter for electric and hybrid vehicles.

The proposed light liquid cooled power electronic unit comprises, in a manner already known in the available state of the art:
several electromagnetic components, each comprising a magnetic core, at least one electroconductive coil wound around the magnetic core, and a bobbin interposed between the at least one electroconductive coil and the magnetic core;
a cooling circuit with a liquid inlet, a liquid outlet, and several intermediate cooling regions, each intermediate cooling region being in close contact with one of said
several electromagnetic components, allowing heat transmission by conduction between the electromagnetic components and the intermediate cooling regions;
a first wall containing at least a first flat manifold constitutive of a portion of the cooling circuit.

According to the above, the liquid cooled power electronic unit comprises a first wall and several electromagnetic components facing said first wall, which can be used as a support structure for the assembly of the power electronic unit. A cooling circuit is also included and configured to provide cooling to said electromagnetic components where the heat is generated during its use.

Each electromagnetic component comprises a magnetic core, at least one electroconductive coil wound around the magnetic core and supported on an interposed bobbin. The electromagnetic components can be, for example, configured as an inductor, a transformer or a filtering choke.

It will be understood that the cooling circuit is a circuit through which a cooling liquid can be circulated. The cooling liquid will be feed into the cooling circuit through the liquid inlet at a first temperature and, after passing through the entire cooling circuit, will be extracted therefrom through the liquid outlet at a second temperature higher than the first temperature, extracting heat from the power electronic unit.

Typically, after being extracted from the cooling circuit, the cooling liquid will be cooled again to the first temperature through a heat sink and recirculated to the liquid inlet, usually by a liquid pump.

The proposed cooling circuit includes, between the liquid inlet and the liquid outlet, several intermediate cooling regions, each one intended to refrigerate one of the several electromagnetic components through heat transmission by conduction, therefore each of the intermediate cooling regions of the cooling circuit being in close contact with one of the electromagnetic components.

In will be understood that, in most applications, close contact means contact through a solid material without an interposed air gab, and typically a distance smaller than 10mm or smaller than 5mm.

The proposed cooling circuit also comprises a first flat manifold defined within a hollow interior of the first wall.

The flat manifold has a cross section with a reduced thickness, smaller than the thickness of the first wall to fit inside it, and a width bigger than its thickness. This configuration maximizes the heat transmission between the cooling liquid and the main surfaces of the first wall and simplifies the construction and installation of the part of the cooling circuit contained therein.

In addition, the present invention further proposes, in a manner not known in the available state of the art the following:
each intermediate cooling region of the cooling circuit is defined within the bobbin of one electromagnetic component of said several electromagnetic components; and
the first flat manifold includes first connection openings oriented towards the electromagnetic components, and each intermediate cooling region of the cooling circuit is tightly connected to the first flat manifold through the first connection openings by a fitting perpendicular to a main surface of the first wall.

According to the above, the intermediate cooling regions of the cooling circuit are defined within the bobbins integrated in the electromagnetic components. As each bobbin is interposed between the magnetic core and the surrounding electroconductive coil, the correspondent intermediate cooling region will be also interposed between the magnetic core and the electroconductive coil, and preferably each intermediate cooling region surrounding the correspondent magnetic core. This configuration maximizes the cooling produced by the cooling circuit on the electromagnetic components, requiring less coolant and allowing for an increase in the power density of the electromagnetic components and a reduction of its size and weight.

Typically, the bobbin includes a tube-shaped wall with a continuous inner surface tightly surrounding a portion of the magnetic core and with a continuous outer surface with the electro-conductive coil supported thereon. The tube-shaped wall may have a circular cross section, a rectangular cross section, or any other cross section adapted to tightly surround a portion of the magnetic core.

Each intermediate cooling region will be contained within the thickness of said tube-shaped wall constitutive of the bobbin.

To simplify and reduce the cost of manufacturing and assembling the liquid cooled power electronic unit it is also proposed to connect each intermediate cooling region to the first flat manifold through first connection openings provided in the first wall.

Each first connection opening perforates the first wall in a direction perpendicular to one of the main surfaces of the first wall, reaching the first flat manifold.

Each intermediate cooling region integrated in one bobbin will include a fitting port oriented in a direction perpendicular to one main surface of the first flat wall, so that the connection between the intermediate cooling region and the first flat manifold is produced in an easy and cheap manner by simply positioning the corresponding electromagnetic component on top of the first wall aligning the fitting ports with the first connection openings.

It will be understood that the first wall will present two opposed main surfaces mostly flat and preferably mostly parallel to each other. The direction perpendicular to the main surface is a direction perpendicular to the flat regions constitutive of most of one of said main surfaces. The fitting port will be a connection port provided for producing a leak-tight connection between two coaxial portions of a circuit only by pushing said two coaxial portions of the circuit one against the other, for example by producing a mutual insertion.

It will be understood that references to geometric position, such as parallel, perpendicular, tangent, etc. allow deviations up to ± 5° from the theoretical position defined by this nomenclature.

### Brief description of the Figures

The foregoing and other advantages and features will be more fully understood from the following detailed description of an embodiment with reference to the accompanying drawings, to be taken in an illustrative and non-limitative manner, in which:

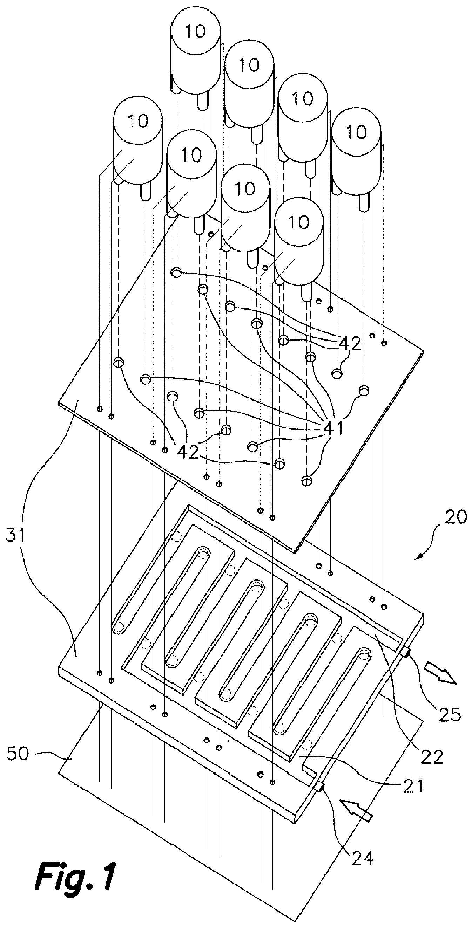

Fig. 1 shows an exploded view of the light liquid cooled power electronic unit devoid of enclosure according to an embodiment of the invention in which the first wall includes a first flat manifold and a second flat manifold, and in which the circuit board is attached to a second side of the first wall opposed to the first wall facing all the electromagnetic components;

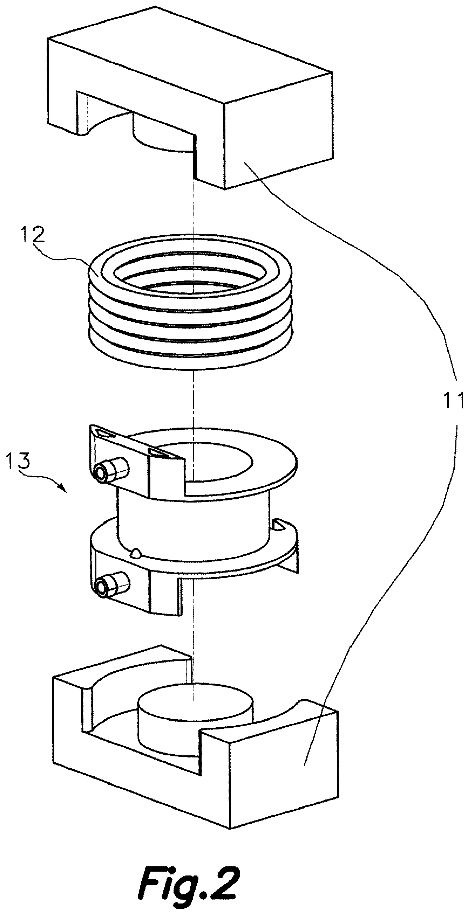

Fig. 2 illustrates an exploded view of one electromagnetic component with a bobbin containing an intermediate cooling region of the cooling circuit, a wire wound around the bobbin and a magnetic core partially inserted in a central through hole of the bobbin;

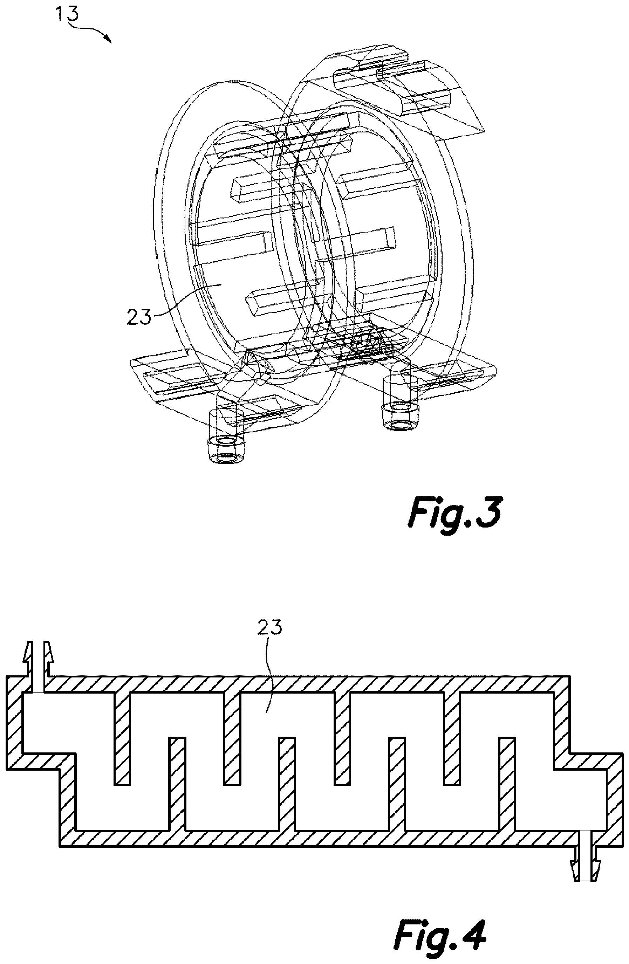

Fig. 3 is a transparent view corresponding to the bobbin of Fig. 2, showing the serpentine-shaped cooling channel defined therein, correspondent to one intermediate cooling region defined inside the cylindrical wall of the bobbin;
Fig. 4 is a schematic view of a flat development of the intermediate cooling region, illustrated in Figs. 3;

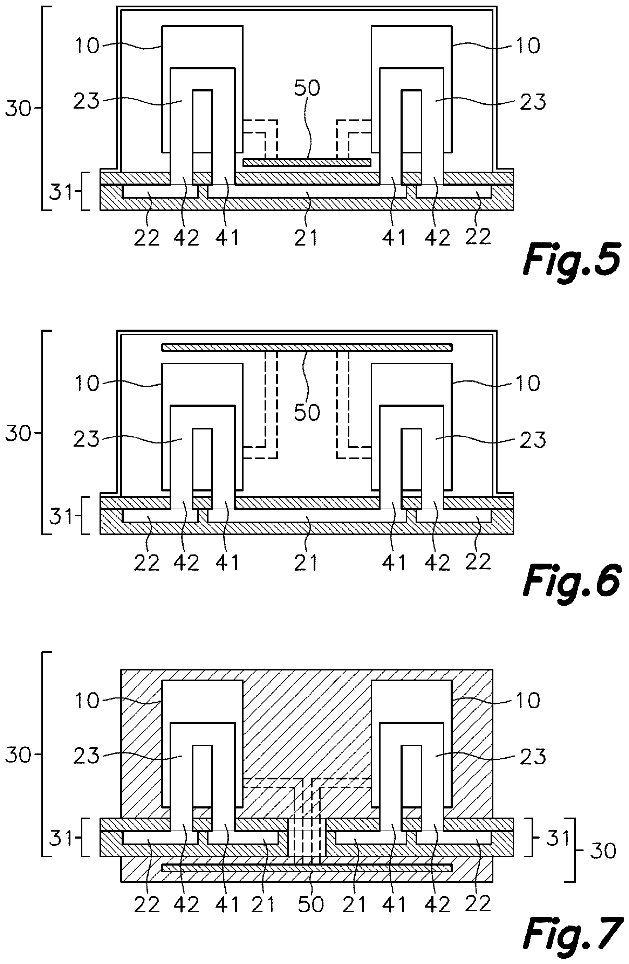

Fig. 5 shows a schematic cross section of the light liquid cooled power electronic unit according to an embodiment of the present invention devoid of a second wall, the first wall containing the first flat manifold and the second flat manifold both connected to each electromagnetic component, and with the circuit board interposed between the first wall and the electromagnetic components, the enclosure including a rigid plastic shell attached to the first wall;
Fig. 6 shows a schematic cross section of the invention according to another embodiment similar to the embodiment shown in Fig. 5 but with the circuit board spaced apart from the first wall, with the electromagnetic components comprised between the circuit board and the first wall;
Fig. 7 shows a schematic cross section of the invention according to another embodiment similar to the embodiment shown in Fig. 5 but with the circuit board attached to a second surface of the first wall, opposed to the first surface facing the electromagnetic components, the electric connections between the circuit board and the electromagnetic components trespassing the first wall through through-holes and wherein the enclosure comprises an overmolded thermal conductive composition supported on the first wall and containing the electromagnetic components and the circuit board;

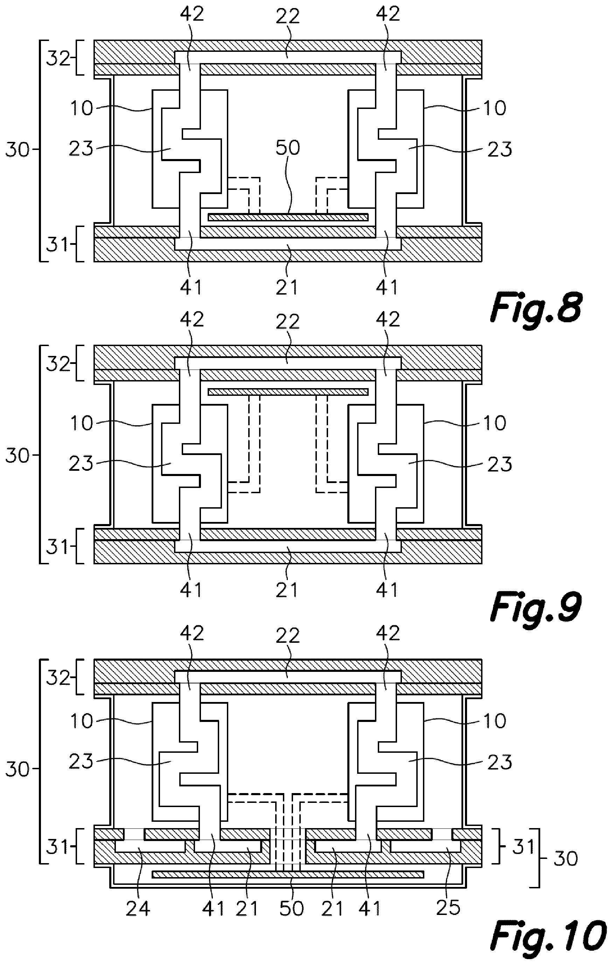

Fig. 8 shows a schematic cross section of the invention according to another embodiment similar to the embodiment shown in Fig. 5 but wherein the second flat manifold is not contained in the first wall but in a second wall parallel to the first wall, the electromagnetic components being comprised between the first and second walls;
Fig. 9 shows a schematic cross section of the invention according to another embodiment similar to the embodiment shown in Fig. 8 but with the circuit board attached to the second wall, spaced apart from the first wall, with the electromagnetic components comprised between the circuit board and the first wall;
Fig. 10 shows a schematic cross section of the invention according to another embodiment similar to the embodiment shown in Fig. 8 but with the circuit board attached to a second surface of the first wall, opposed to the first surface facing the electromagnetic components, the electric connections between the circuit board and the electromagnetic components trespassing the first wall through through-holes and wherein the first wall further comprises a third and fourth flat manifolds connected to the hollow interior of the enclosure for filling said hollow enclosure with a cooling fluid such water or air.

### Detailed Description of the Invention and of particular embodiments

The proposed liquid cooled power electronic unit comprises several electromagnetic components 10, a first wall 31 and a cooling circuit 20 with a liquid inlet 24, a liquid outlet 25, and several intermediate cooling regions 23, each intermediate cooling region 23 being in close contact with one of said several electromagnetic components 10, allowing heat transmission by conduction between the electromagnetic components 10 and the intermediate cooling regions 23. The cooling circuit also includes a first flat manifold 21 contained within the first wall 31.

According to an embodiment, the electromagnetic components 10 are all located facing the same main surface of the first wall, and are attached thereto, so that said first wall constitutes a support frame for the components of the power electronic unit.

Each electromagnetic component 10 comprises a magnetic core 11, at least one electroconductive coil 12 wound around the magnetic core 11, and a bobbin 13 interposed between the at least one electroconductive coil 12 and the magnetic core 11.

Each intermediate cooling region 23 of the cooling circuit 20 is defined within the bobbin 13 of one electromagnetic component 10 of said several electromagnetic components 10, between the magnetic core and the electroconductive component 10.

According to the present invention, the first wall 31 includes first connection openings 41 oriented towards the electromagnetic components 10 and connected to the first flat manifold 21.

Preferably, the first wall 31 is made of two overlapped plates attached to each other in a water-tight manner, at least one of those plates including recesses and/or grooves on a face thereof which, when covered with the other plate, define the first flat manifold 21. According to that, each plate is facing and in contact with the other plate through a contact surface. At least one of the plates includes recesses and/or grooves on said contact surface which get covered when the other plate is overlapped and attached thereto, defining the first flat manifold between both plates.

According to this embodiment, the plate interposed between the first flat manifold and the electromagnetic components 10 is perforated is locations selected to coincide with the first flat manifold, each perforation being perpendicular to the main surface of the first wall and defining one first connection opening 41.

Each intermediate cooling region 23 of the cooling circuit 20 is leak-tightly connected to the first flat manifold 21 through the first connection openings 41 by a fitting perpendicular to a main surface of the first wall 31. This construction permits an easy, cheap, and reliably construction of the power unit.

The electro-insulating bobbin, with the intermediate cooling region 23 therein, may have a bobbin wall defining a closed contour, the bobbin wall including a first outer surface therearound with a closed contour designed for supporting said at least one electroconductive coil, and a first inner surface for the reception of the magnetic core therein. The intermediate cooling region 23 will be contained between the first outer surface and the first inner surface (which may be concentric). The bobbin can further include an inlet port and an outlet port connected to said intermediate cooling region 23, for easily connecting the intermediate cooling region 23 to the rest of the cooling circuit.

Preferably, the intermediate cooling region extends at least around most of said closed contour of the bobbin.

According to the first aspect of the present invention, the intermediate cooling region may be a chamber including several partition walls connecting the first outer surface and the first inner surface, said partition walls being distributed within the chamber to define a serpentine-shaped intermediate cooling region.

The electro-insulating bobbin may be made of a monolithic single piece with the intermediate cooling region embedded therein.

The electro-insulating bobbin may be made of several partial pieces bonded together through bonding surfaces, the intermediate cooling region being defined by one open chamber completely contained within one of the partial pieces and by at least one closure of the open chamber provided by another of the several partial pieces, or by several open chambers, each completely contained within one of the partial pieces, said several open chambers being connected together through connections surrounded by edges of the bonding surfaces.

According to the present invention, the whole electro-insulating bobbin or one part thereof may be made by many thin parallel overlapped layers of additive material produced by a 3D printing process. In such embodiments, the liquid cooled bobbin has uniform and homogeneous properties as there are no multiple parts, joints, welds, etc. that may produce a disruption or change of the properties.

Preferably, the parallel overlapped layers of additive material are transversal to successively interconnected straight segments of the serpentine-shaped intermediate cooling region.

According to an embodiment of the present invention, the electromagnetic components 10 are preferably all facing a first surface of the first wall, and a circuit board 50 parallel to the first wall 31 is attached to a second surface of the first wall 31 opposed to the first surface. The electroconductive coils 12 of the electromagnetic components 10 are connected to the circuit board 50 through through-holes of the first wall 31, perpendiculars thereto, said through-holes not affecting the cooling circuit 20 contained in said first wall 31.

Those through-holes will trespass the first wall through regions containing neither the first flat manifold nor any other portion of the cooling circuit.

This construction allows the active cooling of the circuit board through its contact with the second surface of the first wall, which is cooled at least by the first flat manifold contained therein, and also makes accessible and easily serviceable both the circuit board and the electromagnetic components. Optionally the electromagnetic components can be also cooled through contact through the first surface of the first wall.

According to another alternative embodiment of the present invention, the electroconductive coils 12 of the electromagnetic components 10 are connected to a circuit board 50 parallel to the first wall 31, the electromagnetic components 10 being placed between the first wall 31 and the circuit board 50. This layered construction of the power unit separates the electric connections between the electroconductive components and the circuit board from the cooling fluid connections between the intermediate cooling regions and the portions of the cooling circuit contained in the first wall, not requiring perforation on the first wall for the electrical connections. In this case, the first wall can actuate as a portion of a casing enclosing the power unit.

According to another alternative embodiment, the electroconductive coils 12 of the electromagnetic components 10 are connected to a circuit board 50 parallel to the first wall 31, the circuit board 50 being housed between the first wall 31 and the electromagnetic components 10, the intermediate cooling regions 23 of the cooling circuit 20 passing though said circuit board 50.

According to this embodiment, the circuit board will include through holes through which the intermediate cooling regions are connected to the portion of the cooling circuit defined within the first wall. With this construction, the circuit board can be cooled though contact with the first surface of the first wall, and the electromagnetic components will be cooled by the intermediate cooling regions of the cooling circuit. This construction also permits the first wall to actuate as a portion of an enclosure to protect the power unit.

Preferably, the electromagnetic components 10 and/or the circuit board 50 are/is in close contact with the first wall 31, allowing heat transmission by conduction towards the first wall 31.

The first wall 31 may further contain therein a second flat manifold 22, independent from the first flat manifold 21, and constitutive of another portion of the cooling circuit 20. The construction of the second flat manifold can be the same as that of the first flat manifold described above, i.e. by recesses and/or grooves defined on a face of one plate covered in a water-tight manner with another plate, simultaneously defining first flat manifold 21 and the second flat manifold. Preferably the two manifolds will not intersect within the first wall.

The second flat manifold 22 will include second connection openings 42 oriented towards the electromagnetic components 10, each intermediate cooling region 23 of the cooling circuit 20 being also tightly connected to the second flat manifold 22 through the second connection openings 42 by a fitting perpendicular to the first wall 31.

According to the above, each intermediate cooling region has one end connected to the first flat manifold through one first connection opening, and has another opposed end connected to the second flat manifold through one second connection opening, the cooling liquid passing from the first flat manifold to the second flat manifold through the intermediate cooling regions.

Alternatively, the power electronic unit may comprise a second wall 32, parallel to the first wall 31, which will be contained between the first and second walls.

The second wall 32 will contain at least a second flat manifold 22 constitutive of another portion of the cooling circuit 20, the second flat manifold 22 including second connection openings 42 oriented towards the electromagnetic components 10.

In a manner similar to the first wall, the second wall may be made of two overlapped plates attached to each other in a water-tight manner, at least one of those plates including recesses and/or grooves on a face thereof which, when covered with the other plate, define the second flat manifold 22.

Each intermediate cooling region 23 of the cooling circuit 20 will be tightly connected to the second flat manifold 22 through the second connection openings 42 by a fitting perpendicular to the second wall 32, in the same way as the intermediate cooling regions are connected to the first flat manifold.

This second wall can be added to the different embodiments of the power unit described above, including the circuit board on different positions.

Preferably, the first wall and the second wall 32 are attached to each other retaining the electromagnetic components 10 in between, for example through screws perpendicular to the main surface of the first wall and the main surface of the second wall.

Those screws may apply certain clamping force configured to ensure a water-tight connections through the first and second connections openings 41, 42.

In this case, the electromagnetic components 10 and/or the circuit board 50 are/is preferably in close contact with the second wall 32, allowing heat transmission by conduction towards the second wall 32.

The power electronic unit is preferably housed within an enclosure 30, the first wall 31, or the first and second walls 31, 32, being side walls of said enclosure 30. According to this, the first wall or the first and second walls are also portions of the enclosure which provides protection to the power unit.

When the circuit board and the electromagnetic components are placed on opposed sides of the first wall, the power electronic unit will be housed within an enclosure 30 formed by a first enclosure and a second enclosure separated by the first wall 31, which will be constitutive of a side wall of both first and second enclosures. The electromagnetic components will be housed within the first enclosure and the circuit board will be housed within the second enclosure.

According to an embodiment of the present invention, portions of the enclosure different from the first wall, or different from the first and second walls, are made of rigid plastic, of overmolded composition, of an overmolded thermal conductive composition, or of an overmolded thermal conductive composition comprising a mixture of a silicone resin and at least a first filler including natural mineral filler and optionally further including a second filler including aluminium hydroxide.

According to the above, when the power unit only comprises the first wall, the enclosure is defined by said first wall and by a rigid plastic forming the rest of the enclosure, for example a shell covering all the components of the power unit and with an edge attached to the first wall, for example through screws or adhesive.

Alternatively, the rest of the enclosure is defined by an overmolded composition embedding the electromagnetic components and the circuit board. Said overmolded composition will preferably be a thermal conductive composition, for example comprising a mixture of a silicone resin and at least a first natural mineral filler. To further improve the thermal conductivity of the thermal conductive composition it can further include a second filler including aluminium hydroxide.

When the power unit comprises first wall and second wall parallel to each other, the rest of the enclosure can be defined by a rigid plastic, typically defining several perimetral walls approximately perpendicular to the main surface of the first and second walls and surrounding the components of the power unit comprised between the first and second walls.

Optionally, the space between the first and second walls can be filled with an overmolded composition, for example the thermal conductive composition described above.

The overmolded thermal conductive composition will surround the electromagnetic components and the circuit board and will be in close contact with the first wall or with the first and second walls, allowing heat transmission by conduction between the components where the heat is generated (electromagnetic components and circuit board) and portions of the cooling circuit.

Any of those solutions will reduce the weight of the enclosure of the power unit compared with the traditional enclosure made of thick cast aluminium.

Optionally, when the enclosure is not overmolded but a hollow enclosure, at least a portion of the enclosure, or all the enclosure, can be filled with a thermal conductive composition, for example the thermal conductive composition described above. In this case, the enclosure will be partially defined for example by rigid plastic, which actuate as a mould during the overmolding of the components constitutive of the power unit.

Optionally, the power unit may include an additional cooling circuit, independent from the cooling circuit 20 described above. The additional cooling circuit will include a third flat manifold 25 defined within the first wall or the second wall, a hollow inner volume of the enclosure 30 or part thereof, and a fourth flat manifold 24 defined within the first wall or the second wall, the third flat manifold being in communication with the fourth flat manifold through the hollow inner volume of the enclosure.

According to the above, the cooling liquid will fill the hollow inner volume of the enclosure feed from the third flat manifold 25, cooling the electromagnetic components and/or the circuit board 50 in contact with said cooling liquid. The cooling liquid will be extracted through the fourth flat manifold 24 towards a head sink and later reintroduced through the third flat manifold 25.

The components in contact with the cooling liquid shall be conveniently isolated.

The construction of the third and fourth manifolds will be equivalent to that of the first and second manifolds described above.

## Claims

1. Light liquid cooled power electronic unit comprising:
several electromagnetic components (10), each comprising a magnetic core (11), at least one electroconductive coil (12) wound around the magnetic core (11), and a bobbin (13) interposed between the at least one electroconductive coil (12) and the magnetic core (11);
a cooling circuit (20) with a liquid inlet (24), a liquid outlet (25), and several intermediate cooling regions (23), each intermediate cooling region (23) being in close contact with one of said several electromagnetic components (10), allowing heat transmission by conduction between the electromagnetic components (10) and the intermediate cooling regions (23);
a first wall (31) containing at least a first flat manifold (21) constitutive of a portion of the cooling circuit (20);
**characterized in that**
each intermediate cooling region (23) of the cooling circuit (20) is defined within the bobbin (13) of one electromagnetic component (10) of said several electromagnetic components (10); and
the first flat manifold (21) includes first connection openings (41) oriented towards the electromagnetic components (10), and each intermediate cooling region (23) of the cooling circuit (20) is tightly connected to the first flat manifold (21) through the first connection openings (41) by a fitting perpendicular to a main surface of the first wall (31).

2. The light liquid cooled power electronic unit according to claim 1 wherein the electromagnetic components (10) are facing a first surface of the first wall, a circuit board (50) parallel to the first wall (31) is attached to a second surface of the first wall (31) opposed to the first surface, the electroconductive coils (12) of the electromagnetic components (10) are connected to the circuit board (50) through through-holes of the first wall (31), perpendiculars thereto, said through-holes not affecting the cooling circuit (20) contained in said first wall (31).

3. The light liquid cooled power electronic unit according to claim 1 wherein the electroconductive coils (12) of the electromagnetic components (10) are connected to a circuit board (50) parallel to the first wall (31), the electromagnetic components (10) being placed between the first wall (31) and the circuit board (50).

4. The light liquid cooled power electronic unit according to claim 1 wherein the electroconductive coils (12) of the electromagnetic components (10) are connected to a circuit board (50) parallel to the first wall (31), the circuit board (50) being housed between the first wall (31) and the electromagnetic components (10), the intermediate cooling regions (23) of the cooling circuit (20) passing though said circuit board (50).

5. The light liquid cooled power electronic unit according to claim 1, 2, 3 or 4 wherein the electromagnetic components (10) and/or the circuit board (50) are/is in close contact with the first wall (31), allowing heat transmission by conduction towards the first wall (31).

6. The light liquid cooled power electronic unit according to any preceding claim wherein the first wall (31) further contains therein a second flat manifold (22), independent from the first flat manifold (21), and constitutive of another portion of the cooling circuit (20), the second flat manifold (22) including second connection openings (42) oriented towards the electromagnetic components (10), each intermediate cooling region (23) of the cooling circuit (20) being also tightly connected to the second flat manifold (22) through the second connection openings (42) by a fitting perpendicular to the first wall (31).

7. The light liquid cooled power electronic unit according to any preceding claim 1 to 5 wherein the power electronic unit also comprises a second wall (32), parallel to the first wall (31), the second wall (32) containing at least a second flat manifold (22) constitutive of another portion of the cooling circuit (20), the second flat manifold (22) including second connection openings (42) oriented towards the electromagnetic components (10), each intermediate cooling region (23) of the cooling circuit (20) being also tightly connected to the second flat manifold (22) through the second connection openings (42) by a fitting perpendicular to the second wall (32).

8. The light liquid cooled power electronic unit according to claim 7 wherein the first wall and the second wall (32) are attached to each other retaining the electromagnetic components (10) in between.

9. The light liquid cooled power electronic unit according to claim 7 or 8 wherein the electromagnetic components (10) and/or the circuit board (50) are/is in close contact with the second wall (32), allowing heat transmission by conduction towards the second wall (32).

10. The light liquid cooled power electronic unit according to any preceding claim wherein the first wall (31), or each of the first and second walls (31, 32), is made of two overlapped plates attached to each other in a water-tight manner, at least one of those plates including recesses and/or grooves on a face thereof which, when covered with the other plate, define the first flat manifold (21), the second flat manifold (22) or the first and second flat manifolds (21, 22).

11. The light liquid cooled power electronic unit according to any preceding claim wherein the power electronic unit is housed within an enclosure (30), the first wall (31), or the first and second walls (31, 32), being side walls of said enclosure (30).

12. The light liquid cooled power electronic unit according to claim 2 or according to claims dependent on claim 2 wherein the power electronic unit is housed within an enclosure (30) formed by a first enclosure and a second enclosure separated by the first wall (31), which is constitutive of a side wall of both first and second enclosures, the electromagnetic components being housed within the first enclosure and the circuit board being housed within the second enclosure.

13. The light liquid cooled power electronic unit according to claim 11 or 12 wherein the portions of the enclosure different from the first wall, or different from the first and second walls, are made of rigid plastic, of overmolded composition, of an overmolded thermal conductive composition, or of an overmolded thermal conductive composition comprising a mixture of a silicone resin and at least a first filler including natural mineral filler and optionally further including a second filler including aluminium hydroxide.

14. The light liquid cooled power electronic unit according to claim 11 or 12 wherein at least a portion of the enclosure, or all the enclosure, is filled with thermal conductive composition or with thermal conductive composition comprising a mixture of a silicone resin and at least a first filler including natural mineral filler and optionally further including a second filler including aluminium hydroxide.

15. The light liquid cooled power electronic unit according to claim 11 or 12 wherein an additional cooling circuit, independent from the cooling circuit (20), comprises a third flat manifold (25) defined within the first wall or the second wall, a hollow inner volume of the enclosure (30) or part thereof, and a fourth flat manifold (24) defined within the first wall or the second wall, the third flat manifold being in communication with the fourth flat manifold through the hollow inner volume of the enclosure.
